(19) Europäisches Patentamt
European Patent Office
Office européen des brevets

(11) **EP 1 167 586 A1**

(12) **DEMANDE DE BREVET EUROPEEN**

(43) Date de publication:
**02.01.2002 Bulletin 2002/01**

(51) Int Cl.⁷: **C30B 11/00**, C30B 13/26,
C30B 13/00, C30B 29/48

(21) Numéro de dépôt: **01401610.9**

(22) Date de dépôt: **19.06.2001**

(84) Etats contractants désignés:
**AT BE CH CY DE DK ES FI FR GB GR IE IT LI LU
MC NL PT SE TR**
Etats d'extension désignés:
**AL LT LV MK RO SI**

(30) Priorité: **20.06.2000 FR 0007841**

(71) Demandeur: **Commisariat à l'énergie Atomique
75752 Paris 15ème (FR)**

(72) Inventeurs:
• **Duffar, Thierry
38000 Grenoble (FR)**
• **Garandet, Jean-Paul
38000 Grenoble (FR)**

(74) Mandataire: **Audier, Philippe André
Brevatome, 3, rue du Docteur Lancereaux
75008 Paris (FR)**

(54) **Procédé de cristallogenese avec champ magnetique**

(57)     L'invention concerne un procédé de fabrication d'un monocristal massif d'un matériau électriquement conducteur à l'état fondu, par tirage à partir d'une masse fondue de ce matériau, le matériau présentant lors de sa fusion des agglomérats d'atomes, le procédé comprenant :

- une étape de fusion pour obtenir ladite masse fondue, l'étape de fusion procurant une zone plus froide de la masse fondue, à partir de laquelle sera tiré le monocristal, et une zone plus chaude possédant une température suffisante pour fondre les agglomérats d'atomes,

- une étape d'application à la masse fondue d'un champ magnétique tournant permettant le déplacement des agglomérats d'atomes depuis la zone plus froide jusqu'à la zone plus chaude,

- une étape de croissance du monocristal par tirage après que les agglomérats d'atomes aient été déplacés de la zone plus froide vers la zone plus chaude.

## Description

## Domaine technique

La présente invention concerne la solidification dirigée d'un matériau à partir d'un liquide afin d'obtenir un monocristal. Elle concerne en particulier la solidification mono-directionnelle dans un creuset par les méthodes de tirage Bridgman ou "Gradient Freeze" (refroidissement sous gradient). Elle est particulièrement bien adaptée à la croissance de matériaux composés de type II-VI ou IV-VI.

## Etat de la technique antérieure

Selon les méthodes de croissance directionnelle de cristaux Bridgman ou "Gradient Freeze", on introduit le produit à cristalliser dans un creuset au fond duquel un germe peut avoir été préalablement introduit. Après fusion du produit à solidifier (mais pas du germe) dans un four, on procède à la croissance du cristal soit en déplaçant mécaniquement le creuset dans un gradient thermique, soit en refroidissant lentement le four. Si les vitesses de tirage ou de refroidissement et le gradient thermique sont optimisés, on obtient généralement un monocristal.

Il existe cependant des catégories de matériaux susceptibles d'applications sous forme monocristalline et pour lesquels il est impossible d'obtenir des monocristaux car des grains et des macles apparaissent pendant la croissance du cristal. Il s'agit de matériaux connus sous les appellations génériques II-VI et IV-VI car constitués d'alliages d'éléments appartenant respectivement aux colonnes II et VI ou IV et VI du tableau de Mendeleïev. L'explication de ce phénomène réside dans le fait que, après la fusion, le liquide comprend des agglomérats d'atomes ou "clusters" qui, durant la solidification, se déposent de manière anarchique sur l'interface de croissance et modifient l'orientation du cristal. On peut se référer à ce sujet à l'article "The crystal perfection depends on the superheating of the mother phase too-experimental facts and speculations on the melt structure of semiconductor compounds" de P. RUDOLPH et al., paru dans Journal of Crystal Growth, 166 (1996), pages 578 à 582.

Durant la fusion du matériau, ce qui correspond à la destruction du réseau cristallin, le matériau n'est pas séparé en molécules isolées. Ces molécules restent agglomérées en amas qui présentent donc une certaine orientation cristallographique, différente d'un agglomérat à l'autre. Ces agglomérats s'accumulent en bas de la partie liquide, près de l'interface solide-liquide où ils viennent d'être créés. Si on re-solidifie le liquide, les agglomérats sont incorporés dans le solide selon une orientation cristallographique aléatoire, ce qui constitue autant de sources de désorientation qui empêchent l'obtention d'un monocristal.

Ces agglomérats peuvent être détruits par surchauffe du liquide jusqu'à une certaine température au-dessus de la température de fusion (par exemple pour une surchauffe de 25°C dans le cas du CdTe). En pratique, il est toutefois nécessaire de surchauffer la totalité du liquide, ce qui n'est pas assuré par la convection naturelle régnant dans le liquide, cette convection n'étant pas suffisamment forte pour déplacer les agglomérats situés dans la zone la plus froide du liquide, c'est-à-dire immédiatement au-dessus de l'interface solide-liquide.

Il a été proposé d'utiliser un champ magnétique tournant, au cours de la solidification du matériau, pour stabiliser la convection naturelle de manière à diminuer les fluctuations de température et les fluctuations de composition chimique associées. On peut se référer à ce sujet aux articles de P. DOLD et K.W. BENZ intitulés "Modification of Fluid Flow and Heat Transport in Vertical Bridgman Configurations by Rotating Magnetic Fields" paru dans Cryst. Res. Technol. 32 (1997), 1, pages 51 à 60 et "Rotating Magnetic Fields: Fluid Flow and Crystal Growth Applications" paru dans Progress in Crystal Growth and Characterization of Materials (1997), pages 7 à 38.

## Exposé de l'invention

La présente invention permet de remédier aux problèmes actuels d'obtention de monocristaux de matériaux composés de type II-VI et IV-VI de qualité électronique. Elle consiste à utiliser un champ magnétique tournant afin de déplacer les agglomérats d'atomes ou "clusters" dans une partie du bain de fusion où la température est plus élevée. Les agglomérats fondent dans cette partie du bain alors que le champ de la température au voisinage de l'interface liquide-solide continue à être adapté à la croissance.

Contrairement à l'art antérieur cité ci-dessus, le champ magnétique n'est pas utilisé pour homogénéiser le bain de fusion en température et en composition chimique. Le procédé selon l'invention a pour objet de forcer en quelque sorte la convection naturelle au lieu de la stabiliser. Pour cela, l'application d'un champ magnétique tournant selon l'invention s'effectue avant le début de la solidification alors que, dans l'art antérieur, le champ magnétique exerce son action au cours de l'appauvrissement du bain de l'un des composants du mélange, c'est-à-dire au cours de la croissance.

L'invention a donc pour objet un procédé de fabrication d'un monocristal massif d'un matériau électriquement conducteur à l'état fondu, par tirage à partir d'une masse fondue de ce matériau, le matériau présentant lors de sa fusion des agglomérats d'atomes, le procédé comprenant :

- une étape de fusion pour obtenir ladite masse fondue, l'étape de fusion procurant une zone plus froide de la masse fondue, à partir de laquelle sera tiré le monocristal, et une zone plus chaude possédant une température suffisante pour fondre les agglomérats d'atomes,

- une étape d'application à la masse fondue d'un champ magnétique tournant permettant le déplacement des agglomérats d'atomes depuis la zone plus froide jusqu'à la zone plus chaude,
- une étape de croissance du monocristal par tirage après que les agglomérats d'atomes aient été déplacés de la zone plus froide vers la zone plus chaude, le monocristal se formant à partir de l'extrémité de la masse fondue située du côté de la zone plus froide.

Avantageusement, l'étape de fusion procure une zone plus chaude représentant plus de la moitié du volume de la masse fondue.

De préférence, le tirage s'effectue selon un axe vertical. Dans ce cas, la zone plus froide de la masse fondue peut en constituer la partie inférieure tandis que la zone plus chaude peut en constituer la partie supérieure.

De préférence, l'étape de fusion est menée de façon qu'il y ait une variation régulière de température entre la température de la zone plus froide et la température de la zone plus chaude.

Avantageusement, les caractéristiques du champ magnétique sont telles que la couche limite hydrodynamique, située près de l'interface liquide-solide est réduite le plus possible.

Le tirage du monocristal peut se faire par la méthode Bridgman ou la méthode connue sous l'appellation "Travelling Heater Method" ou THM.

L'invention s'applique notamment à la fabrication d'un monocristal d'un matériau choisi parmi les matériaux de type II-VI et IV-VI.

**Brève description des dessins**

L'invention sera mieux comprise et d'autres avantages et particularités apparaîtront à la lecture de la description qui va suivre, donnée à titre d'exemple non limitatif, accompagnée des dessins annexés parmi lesquels :

- la figure 1 représente de manière schématique et en coupe longitudinale un dispositif de mise en oeuvre du procédé selon l'invention (partie A) et un diagramme représentant la variation de température dans le dispositif le long de son axe longitudinal (partie B),
- les figures 2 et 3 montrent les lignes de convection au niveau de l'interface liquide-solide, respectivement pour le procédé selon l'invention et. pour le procédé selon l'art antérieur.

**Description détaillée d'un mode de réalisation de l'invention**

L'invention consiste à utiliser, avant la solidification, un champ magnétique tournant pour créer une convection forcée et déplacer les agglomérats d'atomes situés dans la zone liquide froide vers la zone liquide chaude où ils sont détruits par l'agitation thermique. On peut ensuite procéder à la solidification.

L'effet du mouvement convectif créé par le champ magnétique est double. D'une part il assure un mouvement plus rapide et plus homogène du liquide que la convection naturelle, ce qui permet de faire disparaître plus rapidement les agglomérats d'atomes. D'autre part, et c'est l'effet le plus important pour l'invention, les caractéristiques géométriques et hydrodynamiques du mouvement convectif font qu'il est particulièrement efficace pour déplacer les agglomérats d'atomes situés près de l'interface solide-liquide. En effet, la vitesse du fluide due au champ magnétique est maximale quelques millimètres seulement au-dessus de l'interface. Dans le cas de la convection naturelle, il s'agit plutôt de centimètres.

La suite de la description va porter sur la mise en oeuvre de l'invention au moyen d'un four Bridgman classique auquel on ajoute un dispositif apte à produire un champ magnétique tournant. Ceci peut être avantageusement réalisé à peu de frais à partir du stator d'un moteur électrique.

La température produite par le four est telle qu'il existe dans la masse fondue une zone plus chaude, de volume supérieur à la moitié de la masse fondue et surchauffée d'au moins une certaine plage de température au-dessus de la température de fusion du matériau. Cette plage de température peut être d'au moins 25°C si le matériau est du CdTe. Avant la solidification, le champ magnétique tournant appliqué permet une homogénéisation de la zone plus froide de la masse fondue, pendant une durée dépendant de la nature du matériau à solidifier. Cette durée peut être d'une heure pour le CdTe.

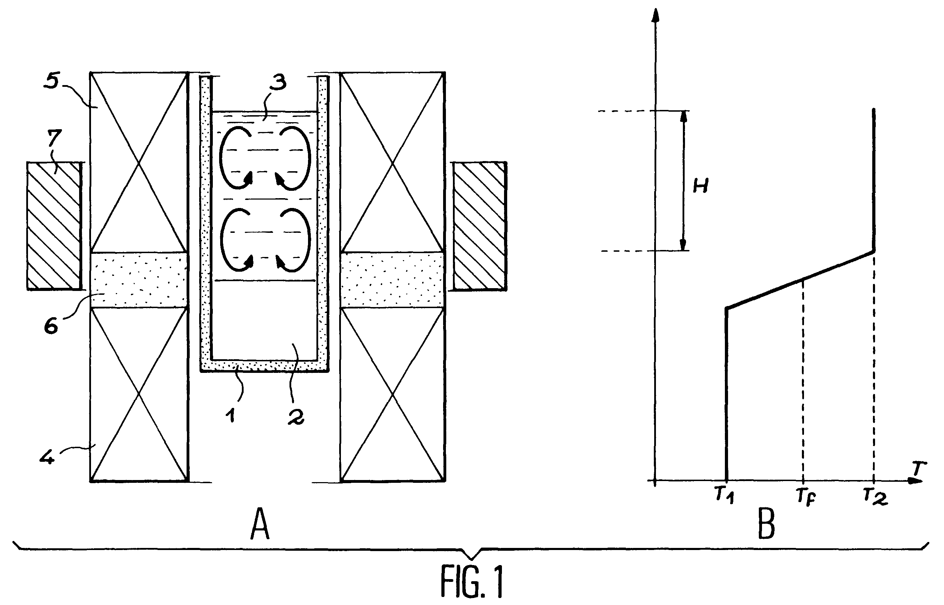

La figure 1 représente, dans sa partie A, un creuset cylindrique 1, au fond duquel a été placé un germe 2. Au-dessus du germe 2 est disposé le matériau 3 à partir duquel on veut fabriquer le monocristal. Le creuset 1 est placé dans un four constitué de deux parties chauffantes 4 et 5 séparées par une zone thermiquement isolante 6 de manière à obtenir à l'intérieur du creuset 1 le profil de température T représenté dans la partie B de la figure 1.

Le profil de température établi pendant l'étape de fusion du matériau est centré sur la température de fusion $T_f$ du matériau. C'est la température qui règne dans le creuset 1 dans la partie de la masse fondue qui est juste en contact avec le germe 2. La partie chauffante 4 produit la température $T_1$ inférieure à la température de fusion du matériau. La partie chauffante 5 produit la température $T_2$ supérieure à la température de fusion du matériau. A ce stade du procédé, le matériau 3 constitue une masse fondue possédant une zone supérieure dite zone chaude, de hauteur H et de température $T_2$ suffisamment éloignée de la température de fusion $T_f$.

L'électro-aimant 7 permet de créer un champ magnétique tournant qui induit dans la masse fondue, électriquement conductrice, un mouvement azimutal et méridional. Ce mouvement est représenté par des flèches dans le matériau 3.

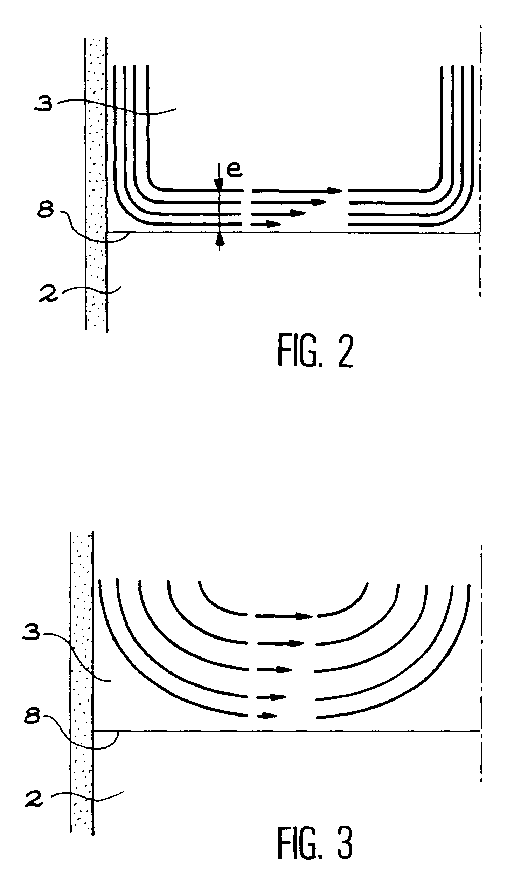

Les figures 2 et 3 sont des vues partielles, et d'un côté de l'axe de symétrie longitudinal du dispositif, montrant l'interface 8 entre le germe 2 et le matériau 3. La figure 2 correspond au cas où un champ magnétique rotatif est appliqué au matériau 3, conformément à l'invention. La figure 3 correspond au cas classique où aucun champ magnétique n'est appliqué. Pour ces deux figures, les lignes de convection ont été représentées. La comparaison de ces deux figures montre bien l'influence d'un champ magnétique rotatif sur les lignes de convection. On constate que le courant de liquide dû à la convection pénètre plus près de l'interface en présence d'un champ magnétique rotatif qu'en son absence, ce qui permet un flux plus élevé d'agglomérats d'atomes vers la zone chaude.

Dans un cas industriel de mise en oeuvre, on peut prendre en compte les considérations suivantes. La capacité de transport des agglomérats d'atomes par un champ magnétique tournant est proportionnelle au produit de la vitesse caractéristique induite dans le fluide par la durée de brassage, ce qui représente la distance moyenne parcourue par les agglomérats d'atomes. On peut se fixer comme critère que, si cette distance est de l'ordre de dix fois la demi-longueur de la zone, les agglomérats d'atomes existants seront détruits. La durée de brassage est un paramètre choisi par l'opérateur, et la vitesse caractéristique du fluide V dépend au premier ordre de l'intensité B du champ magnétique et de sa pulsation ω selon la formule suivante :

$$V = (\sigma\omega/2\rho)^{1/2} \, BR$$

σ et ρ représentent respectivement la conductivité électrique et la masse volumique du fluide, R le rayon du creuset. Pour des paramètres caractéristiques d'une expérience de croissance de CdTe ($\sigma = 5000 \; \Omega^{-1}m^{-1}$, $\rho = 5640 \; kg.m^{-3}$, $R = 2,5cm$), un champ modéré B = 10 mT tournant à une fréquence de 50 Hz induit une vitesse V de l'ordre de 3 mm/s. Pour une demi-longueur de zone liquide de 20 cm, il suffirait donc d'appliquer le champ magnétique tournant sur une durée de 10 minutes avant le début du tirage pour assurer la destruction des agglomérats d'atomes.

On constate alors que la vitesse du fluide est de 3 mm/s dans le cas de l'invention alors qu'elle est de l'ordre de 0,4 mm/s en absence de champ magnétique tournant appliqué.

Toutefois, on peut calculer que la couche d'épaisseur e représentée sur la figure 2, dans laquelle la vitesse du fluide va en diminuant et est donc de moins en moins efficace, présente une épaisseur de 2 mm.

Afin de permettre aux agglomérats d'atomes de se déplacer dans cette couche par agitation thermique, il est nécessaire de porter le temps d'agitation de l'échantillon fondu à 1 heure. On peut diminuer ce temps en augmentant le champ magnétique : avec 25 mT, la couche a une épaisseur d'un mm (elle varie en $B^{-2/3}$) et le temps peut être réduit à ⅓ h (il varie en $e^2$).

L'invention peut être appliquée à la fabrication de monocristaux de composés II-VI et IV-VI, tels que CdTe, HgTe, PbTe, ZnSe et leurs alliages. Elle peut également s'appliquer à d'autres méthodes de croissance de ces composés à partir d'un liquide, en particulier la méthode "Travelling Heater Method" ou THM qui consiste à déplacer une zone fondue, dans un creuset, entre deux parties solides.

L'avantage principal apporté par l'invention est lié à la possibilité d'obtenir des monocristaux, alors que cela est impossible dans l'état actuel des choses pour des matériaux tels que CdTe par exemple.

Par rapport à l'emploi d'un champ magnétique tournant dans l'art antérieur cité plus haut, la présente invention présente les différences suivantes. Le champ magnétique est utilisé avant la solidification et non pendant la solidification. La mise en oeuvre du procédé de l'invention implique donc l'existence d'une étape supplémentaire. Une autre différence réside dans le fait que les caractéristiques du champ magnétique (amplitude, pulsation) soient surtout optimisées de manière à diminuer autant que possible la couche limite hydrodynamique située près de l'interface. Les applications publiées antérieurement optimisent le champ magnétique pour stabiliser la convection naturelle, ce qui conduit à des choix de paramètres différents.

**Revendications**

1.  Procédé de fabrication d'un monocristal massif d'un matériau électriquement conducteur à l'état fondu, par tirage à partir d'une masse fondue de ce matériau (3), le matériau présentant lors de sa fusion des agglomérats d'atomes, le procédé comprenant :

    -   une étape de fusion pour obtenir ladite masse fondue, l'étape de fusion procurant une zone plus froide de la masse fondue, à partir de laquelle sera tiré le monocristal, et une zone plus chaude possédant une température suffisante pour fondre les agglomérats d'atomes,
    -   une étape d'application à la masse fondue d'un champ magnétique tournant permettant le déplacement des agglomérats d'atomes depuis la zone plus froide jusqu'à la zone plus chaude,
    -   une étape de croissance du monocristal par tirage après que les agglomérats d'atomes aient été déplacés de la zone plus froide vers la zone plus chaude, le monocristal se formant à partir de l'extrémité de la masse fondue située du côté de la zone plus froide.

2. Procédé selon la revendication 1, **caractérisé en ce que** l'étape de fusion procure une zone plus chaude représentant plus de la moitié du volume de la masse fondue.

3. Procédé selon l'une des revendications 1 ou 2, **caractérisé en ce que** le tirage s'effectue selon un axe vertical.

4. Procédé selon la revendication 3, **caractérisé en ce que** la zone plus froide de la masse fondue en constitue la partie inférieure tandis que la zone plus chaude en constitue la partie supérieure.

5. Procédé selon l'une quelconque des revendications 1 à 4, **caractérisé en ce que** l'étape de fusion est menée de façon qu'il y ait une variation régulière de température entre la température de la zone plus froide et la température de la zone plus chaude.

6. Procédé selon l'une quelconque des revendications 1 à 5, **caractérisé en ce que** les caractéristiques du champ magnétique sont telles que la couche limite hydrodynamique, située près de l'interface liquide-solide est réduite le plus possible

7. Procédé selon l'une quelconque des revendications 1 à 6, **caractérisé en ce que** le tirage du monocristal se fait par la méthode Bridgman ou la méthode THM.

8. Application du procédé selon l'une quelconque des revendications 1 à 7 à la fabrication d'un monocristal d'un matériau choisi parmi les matériaux de type II-VI et IV-VI.

FIG. 1

EP 1 167 586 A1

FIG. 2

FIG. 3

**Office européen des brevets**

**RAPPORT DE RECHERCHE EUROPEENNE**

Numéro de la demande

EP 01 40 1610

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | SENCHENKOV A S ET AL: "Seedless THM growth of CdxHg1-xTe (x{0.2) single crystals within rotating magnetic field" JOURNAL OF CRYSTAL GROWTH,NL,NORTH-HOLLAND PUBLISHING CO. AMSTERDAM, vol. 197, no. 3, 15 février 1999 (1999-02-15), pages 552-556, XP004156418 ISSN: 0022-0248 * le document en entier * | 1-8 | C30B11/00 C30B13/26 C30B13/00 C30B29/48 |
| A | EP 0 178 987 A (COMMISSARIAT ENERGIE ATOMIQUE) 23 avril 1986 (1986-04-23) * le document en entier * | 1,7,8 | |
| A | EP 0 787 838 A (SHINETSU HANDOTAI KK) 6 août 1997 (1997-08-06) * revendication 1 * | 1,3 | |
| A | SALK M ET AL: "CDTE AND CDTE0.9SE0.1 CRYSTALS GROWN BY THE TRAVELLING HEATER METHOD USING A ROTATING MAGNETIC FIELD" JOURNAL OF CRYSTAL GROWTH,NL,NORTH-HOLLAND PUBLISHING CO. AMSTERDAM, vol. 138, no. 1/04, 2 avril 1994 (1994-04-02), pages 161-167, XP000474525 ISSN: 0022-0248 * le document en entier * | 1,7,8 | **DOMAINES TECHNIQUES RECHERCHES (Int.Cl.7)**<br><br>C30B |

-/--

Le présent rapport a été établi pour toutes les revendications

| Lieu de la recherche | Date d'achèvement de la recherche | Examinateur |
|---|---|---|
| LA HAYE | 10 octobre 2001 | Cook, S |

**EP 1 167 586 A1**

| | Office européen des brevets | **RAPPORT DE RECHERCHE EUROPEENNE** | Numéro de la demande<br>EP 01 40 1610 |

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | WALKER J S: "Bridgman crystal growth with a strong, low-frequency, rotating magnetic field"<br>JOURNAL OF CRYSTAL GROWTH,NL,NORTH-HOLLAND PUBLISHING CO. AMSTERDAM,<br>vol. 192, no. 1-2,<br>15 août 1998 (1998-08-15), pages 318-327,<br>XP004141565<br>ISSN: 0022-0248 | | |
| A,D | DOLD P ET AL: "Rotating magnetic fields: fluid flow and crystal growth applications"<br>PROGRESS IN CRYSTAL GROWTH AND CHARACTERIZATION OF MATERIALS,GB,ELSEVIER PUBLISHING, BARKING,<br>vol. 38, no. 1-4, 1999, pages 7-38,<br>XP004178732<br>ISSN: 0960-8974 | | |
| A | RUDOLPH P ET AL: "DISTRIBUTION AND GENESIS OF INCLUSIONS IN CDTE AND (CD,TN)TE SINGLECRYSTALS GROWN BY THE BRIDGMAN METHOD AND BY THE TRAVELLING HEATER METHOD"<br>JOURNAL OF CRYSTAL GROWTH,NL,NORTH-HOLLAND PUBLISHING CO. AMSTERDAM,<br>vol. 147, no. 3/04,<br>1 février 1995 (1995-02-01), pages 297-304, XP000511972<br>ISSN: 0022-0248<br>* page 302 * | 1,7,8 | DOMAINES TECHNIQUES RECHERCHES (Int.Cl.7) |
| A | US 3 203 768 A (TILLER)<br>31 août 1965 (1965-08-31)<br>* colonne 2, ligne 23 - ligne 34 * | 1 | |

Le présent rapport a été établi pour toutes les revendications

| Lieu de la recherche | Date d'achèvement de la recherche | Examinateur |
|---|---|---|
| LA HAYE | 10 octobre 2001 | Cook, S |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

9

## ANNEXE AU RAPPORT DE RECHERCHE EUROPEENNE
## RELATIF A LA DEMANDE DE BREVET EUROPEEN NO.

EP 01 40 1610

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-10-2001

| Document brevet cité au rapport de recherche | | Date de publication | Membre(s) de la famille de brevet(s) | | Date de publication |
|---|---|---|---|---|---|
| EP 0178987 | A | 23-04-1986 | FR<br>EP | 2572098 A1<br>0178987 A1 | 25-04-1986<br>23-04-1986 |
| EP 0787838 | A | 06-08-1997 | JP<br>EP<br>US | 9208364 A<br>0787838 A1<br>5882398 A | 12-08-1997<br>06-08-1997<br>16-03-1999 |
| US 3203768 | A | 31-08-1965 | US | 3401021 A | 10-09-1968 |

EPO FORM P0460

Pour tout renseignement concernant cette annexe : voir Journal Officiel de l'Office européen des brevets, No.12/82